# EUROPEAN PATENT APPLICATION

(11) **EP 4 506 707 A1**
(43) Date of publication of application: **12.02.2025**
(21) Application number: 24193278.9
(22) Date of filing: 07.08.2024
(51) Int. Cl.: G01R 33/02

(54) **MAGNETIC FIELD DETECTION DEVICE AND MAGNETIC FIELD DETECTION DEVICE ARRAY**

(30) Priority: 08.08.2023 JP 2023128966; 27.03.2024 JP 2024051381
(71) Applicant: TDK Corporation, Tokyo 103-6128 (JP)
(72) Inventor: Yamaji, Yuichiro, Tokyo 103-6128 (JP); Kasajima, Tamon, Tokyo 103-6128 (JP); Kami, Masafumi, Tokyo 103-6128 (JP); Hakakawa, Osamu, Binan, Laguna (PH)
(74) Representative: Epping - Hermann - Fischer

(57) **Abstract**

Disclosed herein is a magnetic field detection device that includes a support having first, second, and third cutouts; and first, second, and third magnetic sensors accommodated in the first, second, and third cutouts, respectively. The support has first and second surfaces extending in first and second directions, third and fourth surfaces extending in the first and third directions, and fifth and sixth surfaces extending in the second and third directions. The first cutout is formed in at least one of the first and fourth surfaces, the second cutout is formed in at least one of the second and fifth surfaces, and the third cutout is formed in at least one of the third and sixth surfaces. Magnetic sensing directions of the first, second, and third magnetic sensors are the first, second, and third directions, respectively.

## Description

### BACKGROUND OF THE ART

### --Field of the Art

The present disclosure relates to a magnetic field detection device and, more particularly, to a magnetic field detection device capable of detecting a magnetic field in three-axis directions. The present disclosure also relates to a magnetic field detection device array having a plurality of such magnetic field detection devices.

### --Description of Related Art

Japanese Unexamined Utility Model Application Publication No. 58-047181 discloses a magnetic field detection device capable of detecting a magnetic field in three-axis directions.

However, the magnetic field detection device disclosed in Japanese Unexamined Utility Model Application Publication No. 58-047181 is disadvantageously likely to have magnetic interference between a plurality of magnetic sensors.

The present disclosure describes a technology for reducing magnetic interference between magnetic sensors in a magnetic field detection device capable of detecting a magnetic field in three-axis directions.

### SUMMARY

A magnetic field detection device according to an aspect of the present disclosure includes a support having first, second, and third cutouts and first, second, and third magnetic sensors respectively accommodated in the first, second, and third cutouts. The support has first and second surfaces extending in a first direction and a second direction perpendicular to the first direction and different in position in a third direction perpendicular to both the first and second directions, third and fourth surfaces extending in the first and third directions and different in position in the second direction, and fifth and sixth surfaces extending in the second and third directions and different in position in the first direction. The first cutout is formed in at least one of the first and fourth surfaces, the second cutout is formed in at least one of the second and fifth surfaces, and the third cutout is formed in at least one of the third and sixth surfaces. The first magnetic sensor has its magnetic sensing direction along the first direction, the second magnetic sensor has its magnetic sensing direction along the second direction, and the third magnetic sensor has its magnetic sensing direction along the third direction. With this configuration, a magnetic field can be detected in three-axis directions by the first to third magnetic sensors, and magnetic interference between the first to third magnetic sensors can be prevented.

According to the present disclosure, there is provided a magnetic field detection device capable of detecting a magnetic field in three-axis directions, offering a technology for reducing magnetic interference between magnetic sensors.

### BRIEF DESCRIPTION OF THE DRAWINGS

The above features and advantages of the present disclosure will be more apparent from the following description of certain preferred embodiments taken in conjunction with the accompanying drawings, in which:
FIGS. 1A and 1B are schematic perspective views as viewed in different directions, which illustrate the outer appearance of a magnetic field detection device 100 according to an embodiment of the technology according to the present disclosure;
FIGS. 2A and 2B are schematic perspective views as viewed from different directions, which illustrates the structure of the support 10;
FIG. 3 is a schematic transparent perspective view of the structure of the magnetic sensor S1, which illustrates a state where a resin case constituting a housing of the magnetic sensor S1 is removed;
FIG. 4 is a schematic perspective view of a magnetic field detection device array having a structure in which a plurality of the magnetic field detection devices 100 are arranged in an array;
FIG. 5 is a schematic diagram for explaining the orientations of the magnetic field detection device 100A and the magnetic field detection device 100B; and
FIGS. 6A to 6C are schematic views for explaining a method of taking out signals output from the three magnetic sensors S1 to S3 included in the magnetic field detection device 100, where FIGS. 6A, 6B, and 6C illustrate first, second, and third examples, respectively.

### DETAILED DESCRIPTION OF THE EMBODIMENTS

Some embodiments of the present disclosure will be explained below in detail with reference to the accompanying drawings.

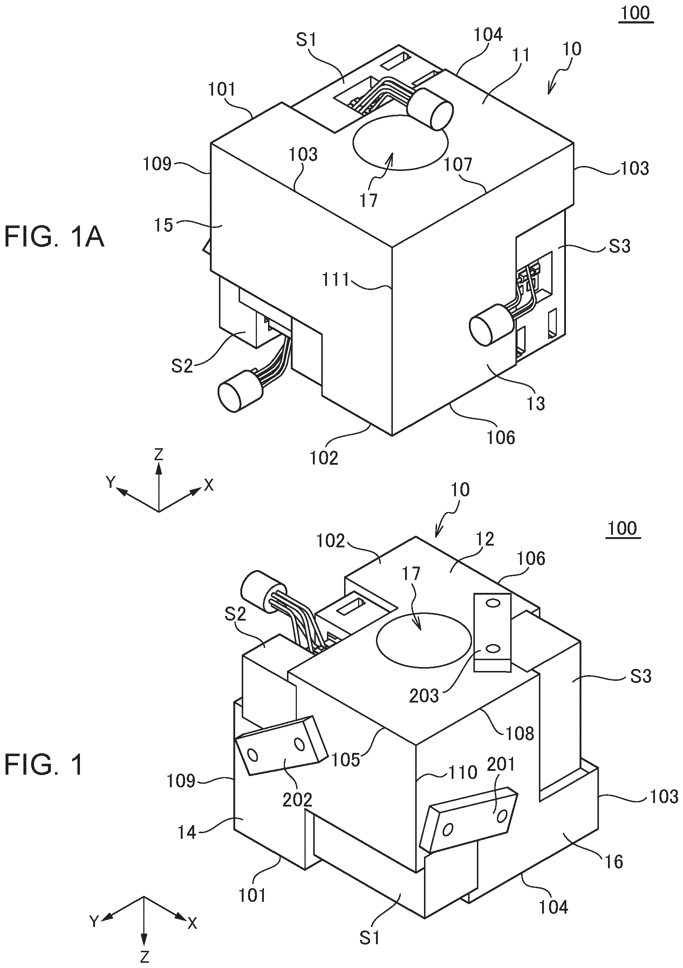

FIGS. 1A and 1B are schematic perspective views as viewed in different directions, which illustrate the outer appearance of a magnetic field detection device 100 according to an embodiment of the technology according to the present disclosure.

As illustrated in FIGS. 1A and 1B, the magnetic field detection device 100 according to the present embodiment includes a support 10 made of a nonmagnetic material such as resin and three magnetic sensors S1 to S3 supported by the support 10.

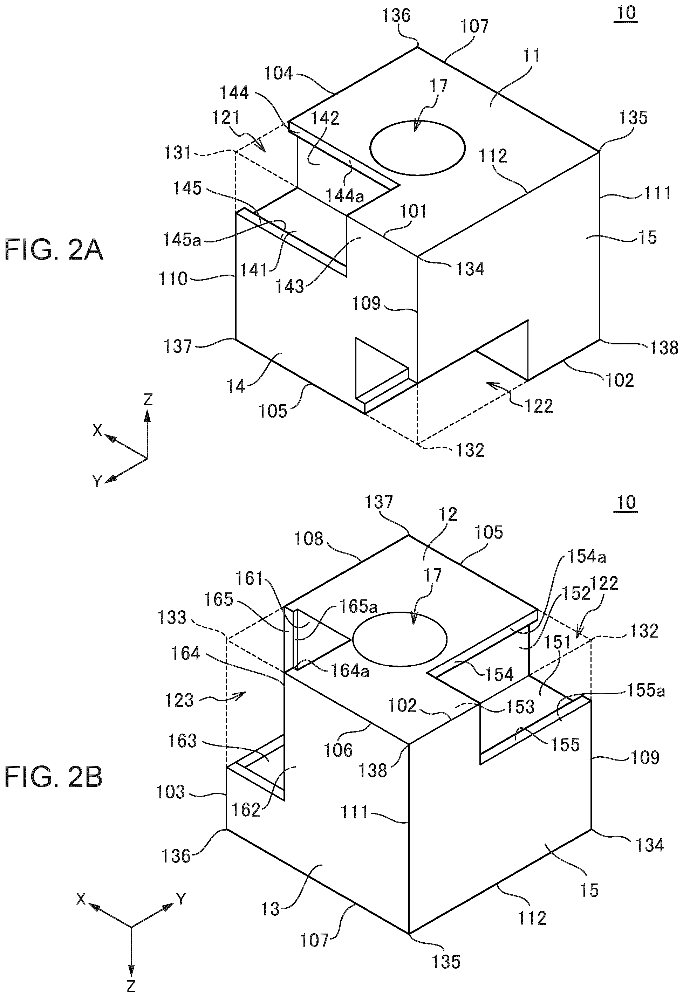

FIGS. 2A and 2B are schematic perspective views as viewed from different directions, which illustrates the structure of the support 10.

As illustrated in FIGS. 2A and 2B, the support 10 has a structure obtained by partially forming cutouts 121 to 123 in a rectangular parallelepiped block. The cutouts 121 to 123 may be formed by machining the rectangular parallelepiped block, or may be formed simultaneously with the support 10 by using a die. According to the latter method, relative positional accuracy between the cutouts 121 to 123 is improved.

The cutouts 121, 122, and 123 respectively accommodate the magnetic sensors S1, S2, and S3. More specifically, the support 10 has surfaces 11, 12 constituting the XY surface and positioned at mutually opposite sides in the Z-direction, surfaces 13, 14 constituting the XZ surface and positioned at mutually opposite sides in the Y-direction, and surfaces 15, 16 constituting the YZ surface and positioned at mutually opposite sides in the X-direction. The support 10 has a through hole 17 extending in the Z-direction from the surface 11 to the surface 12.

In FIGS. 2A and 2B, virtual sides that should originally exist when the support 10 does not have the cutouts 121 to 123 are denoted by dashed lines. That is, when the cutouts 121 to 123 and through hole 17 are absent, the support 10 may have a rectangular parallelepiped shape or a cubic shape. In the example illustrated in FIGS. 2A and 2B, the support 10 has a rectangular parallelepiped shape in which the sizes in the X- and Y-directions are the same, and the size in the Z-direction is slightly smaller than the sizes in the X- and Y-directions.

The surface 11 is perpendicular to surfaces 13 to 16. The end portion of the surface 11 at the positive Y-direction side and the end portion of the surface 14 at the positive Z-direction side constitute a side 101. The end portion of the surface 11 at the negative Y-direction side and the end portion of the surface 13 at the positive Z-direction side constitute a side 107. The end portion of the surface 11 at the positive X-direction side and the end portion of the surface 16 at the positive Z-direction side constitute a side 104. The end portion of the surface 11 at the negative X-direction side and the end portion of the surface 15 at the positive Z-direction side constitute a side 112. The sides 101 and 107 extend in the X-direction, and the sides 104 and 112 extend in the Y-direction.

The surface 12 is perpendicular to surfaces 13 to 16. The end portion of the surface 12 at the positive Y-direction side and the end portion of the surface 14 at the negative Z-direction side constitute a side 105. The end portion of the surface 12 at the negative Y-direction side and the end portion of the surface 13 at the negative Z-direction side constitute a side 106. The end portion of the surface 12 at the positive X-direction side and the end portion of the surface 16 at the negative Z-direction side constitute a side 108. The end portion of the surface 12 at the negative X-direction side and the end portion of the surface 15 at the negative Z-direction side constitute a side 102. The sides 105 and 106 extend in the X-direction, and the sides 102 and 118 extend in the Y=direction.

The surfaces 13, 14 are perpendicular to surfaces 15, 16. The end portion of the surface 13 at the positive X-direction side and the end portion of the surface 16 at the negative Y-direction side constitute a side 103. The end portion of the surface 13 at the negative X-direction side and the end portion of the surface 15 at the negative Y-direction side constitute a side 111. The end portion of the surface 14 at the positive X-direction side and the end portion of the surface 16 at the positive Y-direction side constitute a side 110. The end portion of the surface 14 at the negative X-direction side and the end portion of the surface 15 at the positive Y-direction side constitute a side 109. The sides 103 and 109 to 111 extend in the Z-direction.

The support 10 has eight vertices 131 to 138. Among them, three vertices 131, 132, and 133 have been removed respectively by the cutouts 121, 122, and 123 and are thus virtual vertices that should originally exist when the support 10 has a rectangular parallelepiped shape (or a cubic shape). The vertex 131 is a virtual vertex at which extension lines of the sides 101, 104, and 110 cross one another. In other words, the vertex 131 is constituted by the virtual end points of the surfaces 11, 14, and 16. The vertex 132 is a virtual vertex at which extension lines of the sides 102, 105, and 109 cross one another. In other words, the vertex 132 is constituted by the virtual end points of the surfaces 12, 14, and 15. The vertex 133 is a virtual vertex at which extension lines of the sides 103, 106, and 108 cross one another. In other words, the vertex 133 is constituted by the virtual end points of the surfaces 12, 13, and 16.

In the present embodiment, no cutout is formed at the vertices 134 to 138. That is, the vertices 134 to 138 are actually existing vertices. The vertex 134 is constituted by the terminal portions of the sides 101, 109, and 112. The vertex 135 is constituted by the terminal portions of the sides 107, 111, and 112. The vertex 136 is constituted by the terminal portions of the sides 103, 104, and 107. The vertex 137 is constituted by the terminal portions of the sides 105, 108, and 110. The vertex 138 is constituted by the terminal portions of the sides 102, 106, and 111.

The cutout 121 extends in the X-direction along the side 101 so as to cut the vertex 131. Thus, the surfaces 11, 14, and 16 are partially removed by the cutout 121, and thus the sides 101, 104, and 110 are partially removed. The cutout 121 has an inner wall 141 constituting the XY surface, an inner wall 142 constituting the XZ surface, and an inner wall 143 constituting the YZ surface. The positive Z-direction side of the inner wall 141 is opened except for a part thereof covered with a protrusion part 144 constituting a part of the surface 11. The positive Y-direction side of the inner wall 142 is opened except for a part thereof covered with a protrusion part 145 constituting a part of the surface 14. The positive X-direction side of the inner wall 143 is completely opened.

The X-direction size of the cutout 121 is designed substantially the same as or slightly larger than the X-direction size of the magnetic sensor S1. The Z-direction distance between the inner wall 141 and an inner wall 144a of the protrusion part 144 is designed substantially the same as or slightly larger than the Z-direction size of the magnetic sensor S1. The Y-direction distance between the inner wall 142 and an inner wall 145a of the protrusion part 145 is designed substantially the same as or slightly larger than the Y-direction size of the magnetic sensor S1. With this configuration, when the magnetic sensor S1 is inserted into the cutout 121 in the X-direction, the magnetic sensor S1 is positioned in the Z-direction by the inner wall 141 and the inner wall 144a of the protrusion part 144 and in the Y-direction by the inner wall 142 and the inner wall 145a of the protrusion part 145. After insertion of the magnetic sensor S1 into the cutout 121, a stopper 201 is screwed to the surface 16 so as to cover a part of the cutout 121 in the X-direction, as illustrated in FIG. 1B. This prevents the magnetic sensor S1 from coming off from the cutout 121.

The cutout 122 extends in the Y-direction along the side 102 so as to cut the vertex 132. Thus, the surfaces 12, 14, and 15 are partially removed by the cutout 122, and thus the sides 102, 105, and 109 are partially removed. The cutout 122 has an inner wall 151 constituting the XY surface, an inner wall 152 constituting the YZ surface, and an inner wall 153 constituting the XZ surface. The negative Z-direction side of the inner wall 151 is opened except for a part thereof covered with a protrusion part 154 constituting a part of the surface 12. The negative X-direction side of the inner wall 152 is opened except for a part thereof covered with a protrusion part 155 constituting a part of the surface 15. The positive Y-direction side of the inner wall 153 is completely opened.

The Y-direction size of the cutout 122 is designed substantially the same as or slightly larger than the Y-direction size of the magnetic sensor S2. The Z-direction distance between the inner wall 151 and an inner wall 154a of the protrusion part 154 is designed substantially the same as or slightly larger than the Z-direction size of the magnetic sensor S2. The X-direction distance between the inner wall 152 and an inner wall 155a of the protrusion part 155 is designed substantially the same as or slightly larger than the X-direction size of the magnetic sensor S2. With this configuration, when the magnetic sensor S2 is inserted into the cutout 122 in the Y-direction, the magnetic sensor S2 is positioned in the Z-direction by the inner wall 151 and the inner wall 154a of the protrusion part 154 and in the X-direction by the inner wall 152 and the inner wall 155a of the protrusion part 155. After insertion of the magnetic sensor S2 into the cutout 122, a stopper 202 is screwed to the surface 14 so as to cover a part of the cutout 122 in the Y-direction, as illustrated in FIG. 1B. This prevents the magnetic sensor S2 from coming off the cutout 122.

The cutout 123 extends in the Z-direction along the side 103 so as to cut the vertex 133. Thus, the surfaces 12, 13, and 16 are partially removed by the cutout 123, and thus the sides 103, 106, and 108 are partially removed. The cutout 123 has an inner wall 161 constituting the XZ surface, an inner wall 162 constituting the YZ surface, and an inner wall 163 constituting the XY surface. The negative Y-direction side of the inner wall 161 is opened except for a part thereof covered with a protrusion part 164 constituting a part of the surface 13. The positive X-direction side of the inner wall 162 is opened except for a part thereof covered with a protrusion part 165 constituting a part of the surface 16. The negative Z-direction side of the inner wall 163 is completely opened.

The Z-direction size of the cutout 123 is designed substantially the same as or slightly larger than the Z-direction size of the magnetic sensor S3. The Y-direction distance between the inner wall 161 and an inner wall 164a of the protrusion part 164 is designed substantially the same as or slightly larger than the Y-direction size of the magnetic sensor S3. The X-direction distance between the inner wall 162 and an inner wall 165a of the protrusion part 165 is designed substantially the same as or slightly larger than the X-direction size of the magnetic sensor S3. With this configuration, when the magnetic sensor S3 is inserted into the cutout 123 in the Z-direction, the magnetic sensor S3 is positioned in the Y-direction by the inner wall 161 and the inner wall 164a of the protrusion part 164 and in the X-direction by the inner wall 162 and the inner wall 165a of the protrusion part 165. After insertion of the magnetic sensor S3 into the cutout 123, a stopper 203 is screwed to the surface 12 so as to cover a part of the cutout 123 in the Z-direction, as illustrated in FIG. 1B. This prevents the magnetic sensor S3 from coming off the cutout 123.

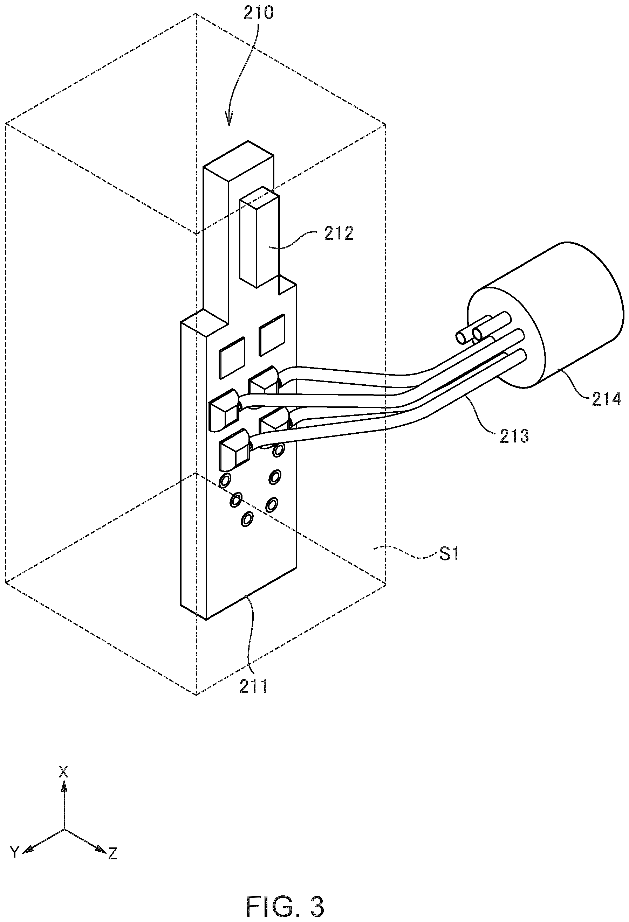

FIG. 3 is a schematic transparent perspective view of the structure of the magnetic sensor S1, which illustrates a state where a resin case constituting a housing of the magnetic sensor S1 is removed.

As illustrated in FIG. 3, the magnetic sensor S1 has a substrate 211 elongated in the X-direction and a magnetosensitive element 212 mounted in the vicinity of the leading end of the substrate 211 in the positive X-direction. The magnetic sensing direction of the magnetosensitive element 212 is the X-direction. Thus, an end face 210 in the positive X-direction of the resin case constituting a housing of the magnetic sensor S1 constitutes a sensor head of the magnetic sensor S1, and an X-direction magnetic field in a space around the end face 210 is detected by the magnetic sensor S1. The magnetosensitive element 212 is connected to a connector 214 by way of cables 213 fixed to the substrate 211.

The magnetic sensors S2 and S3 have the same configuration as the magnetic sensor S1. The magnetic sensor S2 has, in the housing thereof, a magnetosensitive element 212 whose magnetic sensing direction is the Y-direction, and an end face in the positive Y-direction of the resin case constituting the sensor housing constitutes a sensor head. The magnetic sensor S3 has, in the housing thereof, a magnetosensitive element 212 whose magnetic sensing direction is the Z-direction, and an end face in the negative Z-direction of the resin case constituting the sensor housing constitutes a sensor head. That is, the magnetic sensors S1 to S3 may have the same structure.

As described above, in the magnetic field detection device 100 according to the present embodiment, the magnetic sensors S1, S2, and S3 having mutually different sensitivity axis directions are accommodated respectively in the cutouts 121, 122, and 123 formed in the support 10, thereby allowing a magnetic field to be detected in three-axis directions (X-, Y-, and Z-directions). In addition, the cutouts 121, 122, and 123 are respectively arranged along the sides 101, 102, and 103 that do not cross one another (do not have a common vertex), thereby making it possible to prevent physical interference between the magnetic sensors S1 to S3. Further, an appropriate distance can be ensured between the sensor heads of the respective magnetic sensors S1, S2, and S3, making it possible to reduce also magnetic interference between the magnetic sensors S1 to S3.

Further, in the magnetic field detection device 100 according to the present embodiment, the magnetic sensors S1 and S2 do not overlap each other in the Z-direction, and the magnetic sensors S2 and S3 do not overlap each other in the X-direction, thereby preventing magnetic interference between the magnetic sensors S1 and S2 and magnetic interference between the magnetic sensors S2 and S3. Although the magnetic sensors S1 and S3 slightly overlap each other in the Y-direction in the present embodiment, the magnetic sensors S1 and S3 may be configured so as not to overlap each other in the Y-direction by designing the X-, Y-, and Z-direction sizes of the support 10 substantially the same.

Furthermore, the cutouts 121, 122, and 123 have their inner walls for respectively positioning the magnetic sensors S1, S2, and S3, thereby allowing the magnetic sensors S1 to S3 to be positioned along the inner walls of the cutouts 121 to 123 with high accuracy. Further, the magnetic sensors S1 to S3 do not protrude from the surfaces 11 to 16 of the support 10, so that miniaturization can be achieved, and a plurality of the magnetic field detection devices 100 can be arranged in proximity to one another in an array.

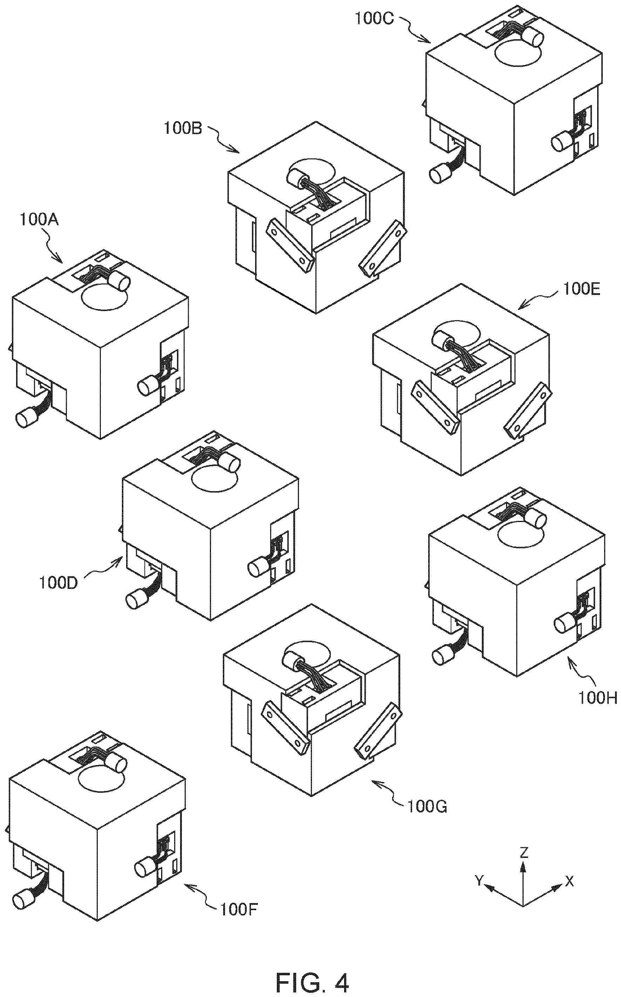

FIG. 4 is a schematic perspective view of a magnetic field detection device array having a structure in which a plurality of the magnetic field detection devices 100 are arranged in an array.

The magnetic field detection device array illustrated in FIG. 4 has a structure in which eight magnetic field detection devices 100A to 100H are arranged in an array. In the example illustrated in FIG. 4, the magnetic field detection devices 100A to 100C are arranged in the X-direction, the magnetic field detection devices 100D and 100E are arranged in the X-direction, and the magnetic field detection devices 100F to 100H are arranged in the X-direction. The positions of the magnetic field detection devices 100A to 100H in the Y-direction are the same. The magnetic field detection devices 100A and 100F are arranged in the Z-direction, the magnetic field detection devices 100B and 100G are arranged in the Z-direction, and the magnetic field detection devices 100C and 100H are arranged in the Z-direction. These magnetic field detection devices 100A to 100H can be fixed at desired positions within a measurement space by means of shafts inserted through the through holes 17 formed in the supports 10.

The X-direction position of the magnetic field detection device 100D is intermediate between the X-direction position of the magnetic field detection devices 100A and 100F and the X-direction position of the magnetic field detection devices 100B and 100G. The Z-direction position of the magnetic field detection device 100D is intermediate between the Z-direction position of the magnetic field detection devices 100A to 100C and the Z-direction position of the magnetic field detection devices 100F to 100H. The X-direction position of the magnetic field detection device 100E is intermediate between the X-direction position of the magnetic field detection devices 100B and 100G and the X-direction position of the magnetic field detection devices 100C and 100H. The Z-direction position of the magnetic field detection device 100E is intermediate between the Z-direction position of the magnetic field detection devices 100A to 100C and the Z-direction position of the magnetic field detection devices 100F to 100H.

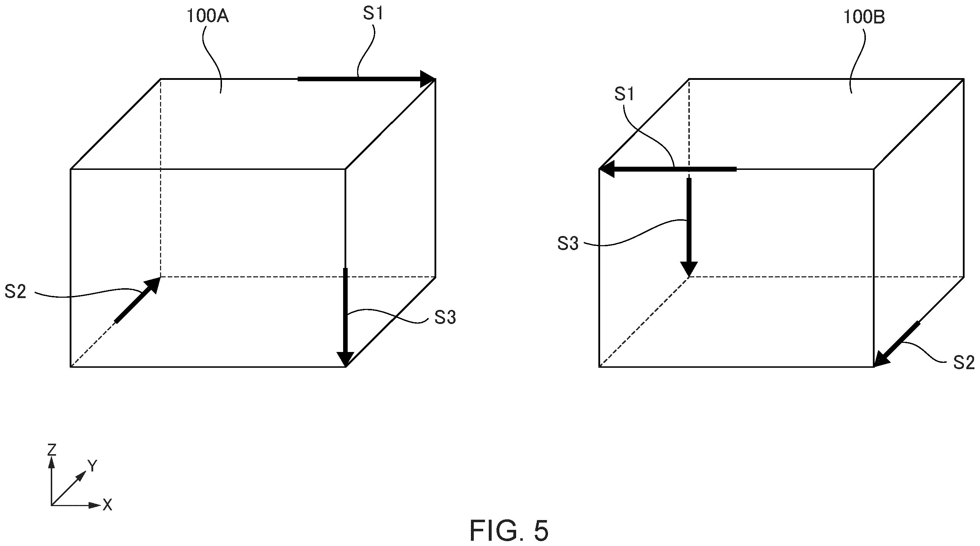

As described above, the array arrangement of the plurality of magnetic field detection devices 100 can detect a magnetic field over a wider space range. In addition, in the example illustrated in FIG. 4, the supports 10 of two magnetic field detection devices adjacent in the X-direction differ in orientation from each other by 180°. Specifically, for example, the support 10 of the magnetic field detection device 100B is fixed in a direction obtained by rotating the support 10 of the magnetic field detection device 100A about the Z-axis. Thus, as illustrated in FIG. 5, the sensitivity axis of the magnetic sensor S1 included in the magnetic field detection device 100A and the sensitivity axis of the magnetic sensor S1 included in the magnetic field detection device 100B do not coincide with each other but are shifted from each other in the Y-direction, thus making it possible to more efficiently detect a magnetic field within a measurement space. In FIG. 5, the direction of each arrow denotes the magnetic sensing direction, and the position thereof denotes a detection position (sensor head position).

Further, although the plurality of magnetic field detection devices are spaced apart from one another in the example illustrated in FIG. 4, they may be arranged such that the supports 10 of adjacent magnetic field detection devices contact one another. When the plurality of magnetic field detection devices are spaced apart from one another, a spacer or the like may be interposed between adjacent magnetic field detection devices so as to fix the interval therebetween.

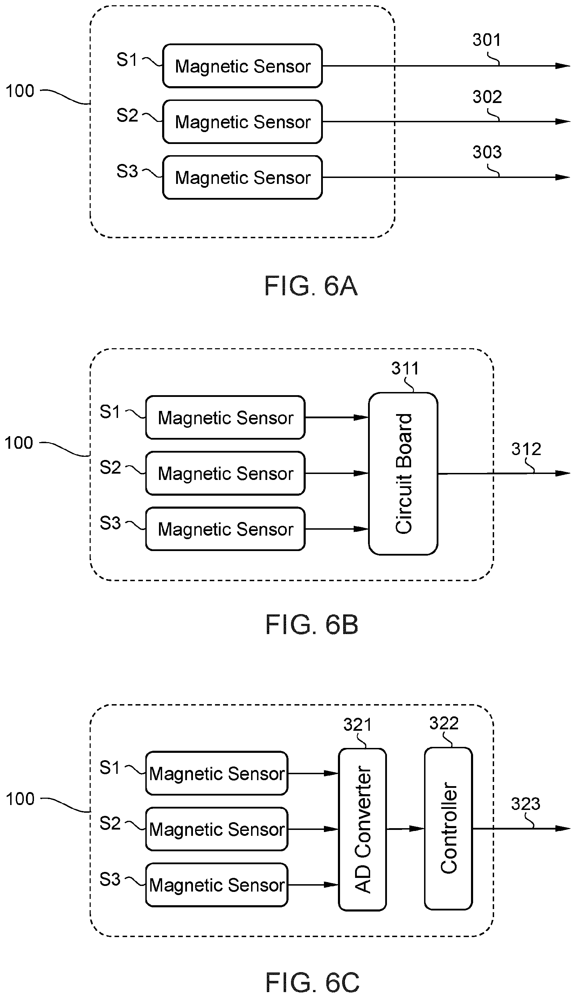

FIGS. 6A to 6C are schematic views for explaining a method of taking out signals output from the three magnetic sensors S1 to S3 included in the magnetic field detection device 100. FIGS. 6A, 6B, and 6C illustrate first, second, and third examples, respectively.

In the first example illustrated in FIG. 6A, cables 301, 302, and 303 connected respectively to the magnetic sensors S1, S2, and S3 are separately drawn from the magnetic field detection device 100. The cables 301, 302, and 303 may include not only signal cables for transmitting signals output from the magnetic sensors S1, S2, and S3 but also power cables for supplying operation power supply to the magnetic sensors S1 to S3 and ground cables. According to the first example of FIG. 6A, the configuration of the magnetic field detection device 100 is made simple.

In the second example illustrated in FIG. 6B, the magnetic field detection device 100 includes a circuit board 311, and the magnetic sensors S1 to S3 are connected to a cable 312 through the circuit board 311. The cable 312 may include not only a signal cable for transmitting signals output from the magnetic sensors S1 to S3 but also a power cable for supplying operation power supply to the magnetic sensors S1 to S3. According to the second example of FIG. 6B, the numbers of cables and connectors externally drawn from the magnetic field detection device 100 can be reduced.

In the third example illustrated in FIG. 6C, the magnetic field detection device 100 includes an AD converter 321 and a controller 322, and the controller 322 is connected with a cable 323. The AD converter 321 AD converts an analog signal output from the magnetic sensors S1 to S3 to generate a digital signal. The digital signal output from the AD converter 321 is supplied to the controller 322 to be subjected to signal processing therein. The controller 322 is connected with the cable 323. The cable 323 may include not only a signal cable for transmitting signals output from the magnetic sensors S1 to S3 but also a power cable for supplying operation power supply to the magnetic sensors S1 to S3. According to the third example of FIG. 6C, a digital signal is output from the magnetic field detection device 100, thus facilitating handling of the magnetic field detection device 100.

While some embodiments of the present disclosure has been described, the present disclosure is not limited to the above embodiments, and various modifications may be made within the scope of the present disclosure, and all such modifications are included in the present disclosure.

For example, although the cutouts 121, 122, and 123 of the support 10 are disposed so as to respectively cut the sides 101, 102, and 103 of the support 10 in the above embodiment, the cutouts 121, 122, and 123 need not respectively cut the sides 101, 102, and 103 themselves. Thus, the cutouts 121, 122, and 123 may be formed respectively along the sides 101, 102, and 103 without respectively cutting the sides 101, 102, and 103 themselves. For example, the cutout 121 may be formed in one of the surfaces 11 and 14 along the side 101, the cutout 122 may be formed in one of the surfaces 12 and 15 along the side 102, and the cutout 123 may be formed in one of the surfaces 13 and 16 along the side 103.

The technology according to the present disclosure includes the following configuration examples, but not limited thereto.

A magnetic field detection device according to an aspect of the present disclosure includes a support having first, second, and third cutouts and first, second, and third magnetic sensors respectively accommodated in the first, second, and third cutouts. The support has first and second surfaces extending in a first direction and a second direction perpendicular to the first direction and different in position in a third direction perpendicular to both the first and second directions, third and fourth surfaces extending in the first and third directions and different in position in the second direction, and fifth and sixth surfaces extending in the second and third directions and different in position in the first direction. The first cutout is formed in at least one of the first and fourth surfaces, the second cutout is formed in at least one of the second and fifth surfaces, and the third cutout is formed in at least one of the third and sixth surfaces. The first magnetic sensor has its magnetic sensing direction along the first direction, the second magnetic sensor has its magnetic sensing direction along the second direction, and the third magnetic sensor has its magnetic sensing direction along the third direction. With this configuration, a magnetic field can be detected in three-axis directions by the first to third magnetic sensors, and magnetic interference between the first to third magnetic sensors can be prevented.

In the above magnetic field detection device, the first magnetic sensor may be accommodated in the first cutout without protruding from the first and fourth surfaces, the second magnetic sensor may be accommodated in the second cutout without protruding from the second and fifth surfaces, and the third magnetic sensor may be accommodated in the third cutout without protruding from the third and sixth surfaces. This can reduce the entire size.

In the above magnetic field detection device, the first cutout may extend along the first direction so as to cut a first side formed by the edges of the first and fourth surfaces, the second cutout may extend along the second direction so as to cut a second side formed by the edges of the second and fifth surfaces, and the third cutout may extend along the third direction so as to cut a third side formed by the edges of the third and sixth surfaces. With this configuration, the first to third sides do not cross one another, preventing physical interference between the first to third magnetic sensors.

In the above magnetic field detection device, the first cutout may be formed so as to cut a first vertex constituted by end points of the first, fourth, and sixth surfaces, the second cutout may be formed so as to cut a second vertex constituted by end points of the second, fourth, and fifth surfaces, and the third cutout may be formed so as to cut a third vertex constituted by end points of the second, third, and sixth surfaces. This allows sensor heads of the first, second, and third magnetic sensors to be respectively disposed in the vicinity of the first, second and third vertices.

In the above magnetic field detection device, the first and second magnetic sensors need not overlap each other in the third direction. This can further reduce magnetic interference between the first and second magnetic sensors.

In the above magnetic field detection device, the second and third magnetic sensors need not overlap each other in the first direction. This can further reduce magnetic interference between the second and third magnetic sensors.

In the above magnetic field detection device, the first and third magnetic sensors need not overlap each other in the second direction. This can further reduce magnetic interference between the first and third magnetic sensors.

A magnetic field detection device array according to an aspect of the present disclosure has a plurality of the above-described magnetic field detection devices. This can detect a magnetic field within a measurement space over a wider range.

In the above magnetic field detection device array, two adjacent ones of the plurality of magnetic field detection devices may be arranged such that their supports differ in orientation from each other by 180°. This can detect a magnetic field within a measurement space more efficiently.

The above magnetic field detection device may further include a first cable connected to the first magnetic sensor, a second cable connected to the second magnetic sensor, a third cable connected to the third magnetic sensor, and a fourth cable for externally and collectively drawing the first, second, and third cables. This can reduce the numbers of cables and connectors externally drawn from the magnetic field detection device.

The above magnetic field detection device may further include an AD converter for AD converting analog signals output from the first, second, and third magnetic sensors and a controller for applying signal processing to the digital signal output from the AD converter. This allows a digital signal to be output from the magnetic field detection device.

## Claims

1. A magnetic field detection device comprising:
a support having first, second, and third cutouts; and
first, second, and third magnetic sensors accommodated in the first, second, and third cutouts, respectively,
wherein the support has:
first and second surfaces extending in a first direction and a second direction perpendicular to the first direction and different in position in a third direction perpendicular to both the first and second directions;
third and fourth surfaces extending in the first and third directions and different in position in the second direction; and
fifth and sixth surfaces extending in the second and third directions and different in position in the first direction,
wherein the first cutout is formed in at least one of the first and fourth surfaces,
wherein the second cutout is formed in at least one of the second and fifth surfaces,
wherein the third cutout is formed in at least one of the third and sixth surfaces,
wherein a magnetic sensing direction of the first magnetic sensor is the first direction,
wherein a magnetic sensing direction of the second magnetic sensor is the second direction, and
wherein a magnetic sensing direction of the third magnetic sensor is the third direction.

2. The magnetic field detection device as claimed in claim 1,
wherein the first magnetic sensor is accommodated in the first cutout without protruding from the first and fourth surfaces,
wherein the second magnetic sensor is accommodated in the second cutout without protruding from the second and fifth surfaces, and
wherein the third magnetic sensor is accommodated in the third cutout without protruding from the third and sixth surfaces.

3. The magnetic field detection device as claimed in claim 1 or 2,
wherein the first cutout extends along the first direction so as to cut a first side formed by edges of the first and fourth surfaces,
wherein the second cutout extends along the second direction so as to cut a second side formed by edges of the second and fifth surfaces, and
wherein the third cutout extends along the third direction so as to cut a third side formed by edges of the third and sixth surfaces.

4. The magnetic field detection device as claimed in claim 3,
wherein the first cutout is formed so as to cut a first vertex constituted by end points of the first, fourth, and sixth surfaces,
wherein the second cutout is formed so as to cut a second vertex constituted by end points of the second, fourth, and fifth surfaces, and
wherein the third cutout is formed so as to cut a third vertex constituted by end points of the second, third, and sixth surfaces.

5. The magnetic field detection device as claimed in any one of claims 1 to 4, wherein the first and second magnetic sensors do not overlap each other in the third direction.

6. The magnetic field detection device as claimed in claim 5, wherein the second and third magnetic sensors do not overlap each other in the first direction.

7. The magnetic field detection device as claimed in claim 6, wherein the first and third magnetic sensors do not overlap each other in the second direction.

8. The magnetic field detection device as claimed in any of claims 1 to 7, wherein a plurality of the magnetic field detection devices are arranged in an array.

9. The magnetic field detection device as claimed in claim 8, wherein two adjacent ones of the plurality of magnetic field detection devices are arranged such that their supports differ in orientation from each other by 180°.

10. The magnetic field detection device as claimed in any one of claims 1 to 7, further comprising:
a first cable connected to the first magnetic sensor;
a second cable connected to the second magnetic sensor;
a third cable connected to the third magnetic sensor; and
a fourth cable for externally and collectively drawing the first, second, and third cables.

11. The magnetic field detection device as claimed in any one of claims 1 to 7, further comprising:
an AD converter for AD converting analog signals output from the first, second, and third magnetic sensors into digital signals; and
a controller for applying signal processing to the digital signals output from the AD converter.
